# EUROPEAN PATENT APPLICATION

(11) **EP 1 595 979 A1**
(43) Date of publication of application: **16.11.2005**
(21) Application number: 04705945.6
(22) Date of filing: 28.01.2004
(51) Int. Cl.: C30B 29/28, C30B 19/12, G02F 1/09

(54) **SUBSTRATE FOR FORMING MAGNETIC GARNET SINGLE-CRYSTAL FILM, PROCESS FOR PRODUCING THE SAME, OPTICAL DEVICE AND PROCESS FOR PRODUCING THE SAME**

(30) Priority: 04.02.2003 JP 2003027165
(71) Applicant: TDK Corporation, Chuo-ku, Tokyo 103-8272 (JP)
(72) Inventor: UCHIDA, Kiyoshi, Chuo-ku, Tokyo 1038272 (JP); SAKASHITA, Yukio, Chuo-ku, Tokyo 1038272 (JP); OHIDO, Atsushi, Chuo-ku, Tokyo 1038272 (JP)
(74) Representative: Vossius & Partner
(86) International application number: PCT/JP2004/000760
(87) International publication number: WO 2004/070091

(57) **Abstract**

A method of producing a magnetic garnet single crystal film formation substrate 2 for growing a magnetic garnet single crystal film by liquid phase epitaxial growth is provided. First, a base substrate 10 composed of a garnet-based single crystal being unstable with a flux used for the liquid phase epitaxial growth is formed. Next, a buffer layer 11 composed of a garnet-based single crystal thin film formed at least on a crystal growing surface of said base substrate 10 and being stable with the flux is formed. When forming the buffer layer 11 on the base substrate 10, it is formed by a thin film formation method, such as sputtering, without heating the substrate 10 in a positive manner.

## Description

### TECHNICAL FIELD

The present invention relates to a production method of a magnetic garnet single crystal film formation substrate for growing a magnetic garnet single crystal film of, for example, bismuth-substituted rare earth iron garnet (Bi-RIG) by liquid phase epitaxial growth, a substrate produced by using the production method, a method of producing a single crystal film for performing crystal growth by using the substrate, and a single crystal film and an optical element produced by the production method.

### BACKGOUND ART

As a material of an optical element, such as a Faraday rotator used in an optical isolator, optical circulator and optical magnetic field sensor, etc., what obtained by growing a magnetic garnet single crystal film on a single crystal substrate by epitaxial growth is generally used. The magnetic garnet single crystal film to be grown on the substrate is desired to have a large Faraday rotation coefficient to obtain desired Faraday effects. Also, to form a high quality single crystal film by epitaxial growth, it is required that a lattice constant difference between the substrate single crystal and the single crystal to be grown is as small as possible in a temperature range from a film forming temperature to the room temperature.

It is known that the Faraday rotation coefficient of the magnetic garnet single crystal film remarkably increases by substituting a part of the rare earth components with bismuth. An increase of a bismuth substitution amount brings an increase of a lattice constant of the magnetic garnet single crystal film at the same time, so that a substrate material used for the film forming is also required to have a larger lattice constant and, for example, gadolinium gallium garnet (GGG) added with Ca, Zr and Mg, etc. to obtain a large lattice constant is used as the single crystal substrate material (refer to the patent article 1: The Japanese Examined Patent Publication No. 60-4583).

However, in the case of growing bismuth-substituted rare earth iron garnet single crystal on the GGG single crystal substrate added with Ca, Zr and Mg, etc. to be a thick film (a film thickness of, for example, 200 µm or more), the substrate and the single crystal layer during and after the film forming are liable to warp and crack, which is a cause of declining production yields at the time of the film forming and processing.

To eliminate the problem, the present inventors have proposed a garnet single crystal substrate of a specific composition wherein a thermal expansion coefficient within a face being perpendicular to the crystal orientation <111> is a value extremely close to that of the bismuth-substituted rare earth iron garnet in a temperature range from the room temperature to 850°C (refer to the patent particle 2: The Japanese Unexamined Patent Publication No. 10-139596). By using this single crystal substrate, it is possible to form a thick film bismuth-substituted rare earth iron garnet single crystal film by liquid phase epitaxial growth wherein crystal defects, warps and cracks, etc. are not caused.

However, it was found by the present inventors that the garnet single crystal substrate of this specific composition was unstable with lead oxide flux used as a deposition medium at the time of performing the liquid phase epitaxial growth of bismuth-substituted rare metal iron garnet (Bi-RIG) single crystal film, so the yields of obtaining high quality bismuth-substituted rare earth iron garnet single crystal was poor. Particularly, it was found that this tendency was strong in a substrate composition containing Nb or Ta.

Thus, the present inventors have developed a substrate, wherein a buffer layer made by a garnet based single crystal thin film being stable with a flux is formed on a film forming surface of a base substrate made by a garnet based single crystal being unstable with a flux, and filed previously (refer to the patent article 3: PCT/JP02/06223).

As a means for forming a buffer layer on a crystal growing surface of the base substrate, a various thin film formation methods, such as the sputtering method, can be applied. However, in the related art, when forming a buffer layer by a thin film formation method, it was considered that a substrate temperature at the time of forming the film had to be high as 600°C or higher to obtain a high quality buffer layer. Therefore, heating and cooling of the substrate require a long time (some hours to tens of hours) and a high performance heater is required as a heater for heating the substrate, so that an increase of the production cost becomes a problem, such as an increase of the production procedure time and an increase of the production apparatus cost.

The present invention was made in consideration of the above circumstances and has an object thereof to provide a magnetic garnet single crystal film formation substrate capable of stably forming a thick magnetic garnet single crystal film, wherein crystal defects, warps, cracks and flaking, etc. are not caused, having a high quality at a high yield at a low cost by liquid phase epitaxial growth, and an optical element and the production method.

### DISCLOSURE OF THE INVENTION

To attain the above object, there is provided a method of producing a magnetic garnet single crystal film formation substrate for growing a magnetic garnet single crystal film by liquid phase epitaxial growth, comprising the steps of:
forming a base substrate composed of a garnet-based single crystal being unstable with a flux used for the liquid phase epitaxial growth;
forming a buffer layer composed of a garnet-based single crystal thin film formed at least on a crystal growing surface of said base substrate and being stable with said flux; and
forming said buffer layer on said base substrate without a positive heating of said substrate when forming said buffer layer on said base substrate.

According to a second aspect of the present invention, there is provided a method of producing a magnetic garnet single crystal film formation substrate for growing a magnetic garnet single crystal film by liquid phase epitaxial growth, comprising the steps of:
forming a base substrate composed of a garnet-based single crystal being unstable with a flux used for the liquid phase epitaxial growth;
forming a buffer layer composed of a garnet-based single crystal thin film formed at least on a crystal growing surface of said base substrate and being stable with said flux; and
forming said buffer layer on said base substrate by controlling a temperature of said substrate to be from the room temperature to lower than 600°C when forming said buffer layer on said base substrate.

The above flux is not particularly limited, but is a flux including, for example, a lead oxide and/or a bismuth oxide. Note that "being unstable with a flux" in the present invention means that, in a so-called supersaturated state where a solute component in the flux starts to crystallize by using an object substance (a base substrate or buffer layer) as a core, at least a part of a material composing the object substance is eluted to the flux and/or at least a part of the flux component is diffused to the object substance to hinder the liquid phase epitaxial growth of a single crystal film. Also, "being stable with a flux" means a reverse phenomenon of the "being unstable with a flux".

According to the present invention, it is possible to select a garnet single crystal substrate of a specific composition having an extremely close thermal expansion coefficient to that of a magnetic garnet single crystal, for example, bismuth-substituted rare earth iron garnet to be an object of forming by liquid phase epitaxial growth and, even when the substrate is unstable with the flux, stable liquid phase epitaxial growth can be performed. It is because a buffer layer being stable with a flux is formed on the base substrate.

Thus, in the present invention, a bismuth-substituted rare earth iron garnet single crystal film used in a Faraday rotator and other optical elements can be formed by liquid phase epitaxial growth at a high quality at a high production yield while suppressing arising of crystal defects, warps, cracks and flaking, etc. Namely, according to the present invention, a relatively thick (for example, 200 µm or more) and wide (for example, a diameter of 3 inches or more) magnetic garnet single crystal film can be obtained by liquid phase epitaxial growth.

Particularly, in the present invention, when forming a buffer layer, the substrate is not heated in a positive manner or the temperature is managed to be from the room temperature to lower than 600°C, preferably the room temperature to 300°C, and particularly preferably the room temperature to 100°C if heated to form a buffer layer on the base substrate. Therefore, in the present invention, a time required for heating and cooling the substrate can be widely reduced. Also, it is not necessary to use a high performance heater, so that an increase of the production cost due to investment on a new production equipment can be suppressed.

Note that it was found by the present inventors for the first time that a high quality buffer layer can be formed without heating the substrate in a positive manner. In a thin film formation method, such as sputtering, the substrate temperature rises even if the substrate is not heated in a positive manner, but in the present invention, the substrate is not heated in a positive manner in this case.

Preferably, after forming a buffer layer on the base substrate, the buffer layer is subjected to anneal processing at a temperature of 600 to 900°C. When the temperature of the anneal processing is too low, crystallization of the buffer layer becomes insufficient and it is liable that a high quality buffer layer is hard to be obtained, while when the temperature is too high, it is liable that a crystal quality of the buffer layer becomes deteriorated.

Preferably, the buffer layer is formed by a thin film formation method, such as the sputtering method. The present inventors found that a high quality buffer layer can be formed by performing annealing processing in the later step even if the substrate is not heated in a positive manner when forming a buffer layer by a thin film formation method, such as the sputtering method.

Preferably, when forming the buffer layer by the sputtering method, oxygen (O₂) is included by 35 volume% or less, and more preferably 10 to 30 volume% in an atmosphere gas (an inert gas, such as Ar) at the time of sputtering. In an atmosphere gas not including oxygen at all, crystal quality of the buffer layer tends to become deteriorated, while when the oxygen amount is too much, abnormal discharging, etc. are caused and it is liable that a high quality buffer layer is hard to be obtained.

Preferably, input power at the time of sputtering is controlled to be 2 to 10 W/cm², and more preferably 3 to 6 W/cm² when forming the buffer layer by the sputtering method. By controlling the input power to be in the ranges, a high quality buffer layer can be formed. When the input power is too small, it is liable that the film forming speed becomes slow and the productivity declines, while when too large, it is liable that the base substrate is damaged to deteriorate the crystal property and braking of the sputtering target, etc. arise.

Preferably, the base substrate has approximately the same thermal expansion coefficient as that of the magnetic garnet single crystal film. For example, in a temperature range of 0°C to 1000°C, the difference of the thermal expansion coefficient of the base substrate is within a range of ±2 × 10⁻⁶/°C or less with respect to the thermal expansion coefficient of the magnetic garnet single crystal film.

By making the thermal expansion coefficient of the base substrate approximately the same with that of the magnetic garnet single crystal film, deterioration of the quality, such that a film after epitaxial growth comes off from the substrate and cracks and chips, etc. (hereinafter, also referred to as "cracks, etc."), can be effectively prevented. It is because, at the time of forming a magnetic garnet single crystal film by epitaxial growth, the temperature rises nearly 1000°C and returns to the room temperature, so cracks, etc. easily arise on the epitaxial growth film when the thermal expansion coefficients are different.

Note that the thermal expansion coefficient of the buffer layer is not necessarily approximately the same with that of the magnetic garnet single crystal film. It is because a film thickness of the buffer layer is extremely thin with respect to a thickness of the base substrate and the thermal expansion difference affects a little on the epitaxial growth film.

Preferably, the base substrate has approximately the same lattice constant as that of the magnetic garnet single crystal film. For example, the difference of the lattice constant of the base substrate is in a range of ±0.02Å or less with respect to the lattice constant of the magnetic garnet single crystal film.

By making the lattice constant of the base substrate approximately the same as that of the magnetic garnet single crystal film, the magnetic garnet single crystal film is easily grown by liquid phase epitaxial growth.

Preferably, the base substrate includes Nb or Ta. When Nb or Ta is included in the base substrate, the thermal expansion coefficient and/or lattice constant of the base substrate is easily made approximately the same as the lattice constant of the magnetic garnet single crystal film. Note that when Nb or Ta is included in the base substrate, stability with a flux is liable to decline.

Preferably, the buffer layer is a garnet-based single crystal thin film substantially not including Nb and Ta. It is because a garnet-based single crystal thin film substantially not including Nb and Ta is relatively stable with a flux.

Preferably, the buffer layer is
expressed by a general formula R₃M₅O₁₂ (note that R is at least one of rare earth elements and M is one selected from Ga and Fe)
   or
an X-substituted gadolinium gallium garnet (note that X is at least one of Ca, Mg and Zr).

The buffer layer composed of a material as above is preferable for being relatively stable with a flux and, moreover, having a lattice constant close to that of a magnetic garnet single crystal film.

Preferably, a thickness of the buffer layer is 1 to 10000 nm, more preferably 5 to 50 nm, and a thickness of the base substrate is 0.1 to 5 mm, more preferably 0.2 to 2.0 mm. When the thickness of the buffer layer is too thin, an effect of the present invention becomes small, while when it is too thick, the cost becomes high and it is liable to adversely affect on the epitaxial growth film, such as cracks, due to a difference of thermal expansion coefficient. Also, when the thickness of the base substrate is too thin, it is liable that mechanical strength becomes insufficient and handling becomes deteriorated, while when it is too thick, arising of cracks, etc. is liable to increase.

A method of producing a magnetic garnet single crystal film according to the present invention includes the step of growing a magnetic garnet single crystal film on the buffer layer by using the magnetic garnet single crystal film formation substrate of the present invention by a liquid phase epitaxial growth method.

A method of producing an optical element according to the present invention includes the steps of forming a magnetic garnet single crystal film by using the method of producing a magnetic garnet single crystal film of the present invention, and after that, removing the base substrate and buffer layer in order to form an optical element composed of the magnetic garnet single crystal film.

Preferably, by removing the base substrate and the buffer layer, and
leaving only a magnetic garnet single crystal film formed on a crystal growing surface of the base substrate,
an optical element composed of the magnetic garnet single crystal film is formed.

In the present invention, a buffer layer may be formed not only on the crystal growing surface of the base substrate but also on side surfaces crossing with the crystal growing surface. In that case, a magnetic garnet film is formed also on side surfaces of the base substrate. In the present invention, the magnetic garnet film formed on the side surfaces of the base substrate has a poorer quality comparing with the magnetic garnet single crystal film formed on a crystal growth surface of the base substrate, so that this part is preferably removed for using as an optical element.

An optical element according to the present invention is obtained by the method of producing an optical element of the present invention.

### BRIEF DESCRIPTION OF DRAWINGS

Below, the present invention will be explained based on embodiments shown in drawings.
FIG. 1A and FIG. 1B are schematic sectional views of a production procedure of a magnetic garnet single crystal film formation substrate according to an embodiment of the present invention, and FIG. 1C is a schematic sectional view of a step of forming a single crystal film on the magnetic garnet single crystal film formation substrate;
FIG. 2 is a schematic view of a sputtering apparatus;
FIG. 3 is a schematic view of an apparatus for growing crystal;
FIG. 4 is an optical microscope picture of a surface when growing crystal by using a magnetic garnet single crystal film formation substrate according to an example of the present invention;
FIG. 5 is a sectional view of a magnetic garnet single crystal film formation substrate according to another embodiment of the present invention and a single crystal film grown by using the same;
FIG. 6 is a an optical microscope picture of a surface when growing crystal by using the magnetic garnet single crystal film formation substrate shown in FIG. 5; and
FIG. 7 is a SEM image of a surface in a state of forming a single crystal film on a surface of a magnetic garnet single crystal film formation substrate according to a comparative example of the present invention;

### BEST MODE FOR CARRYING OUT THE INVENTION

### First Embodiment

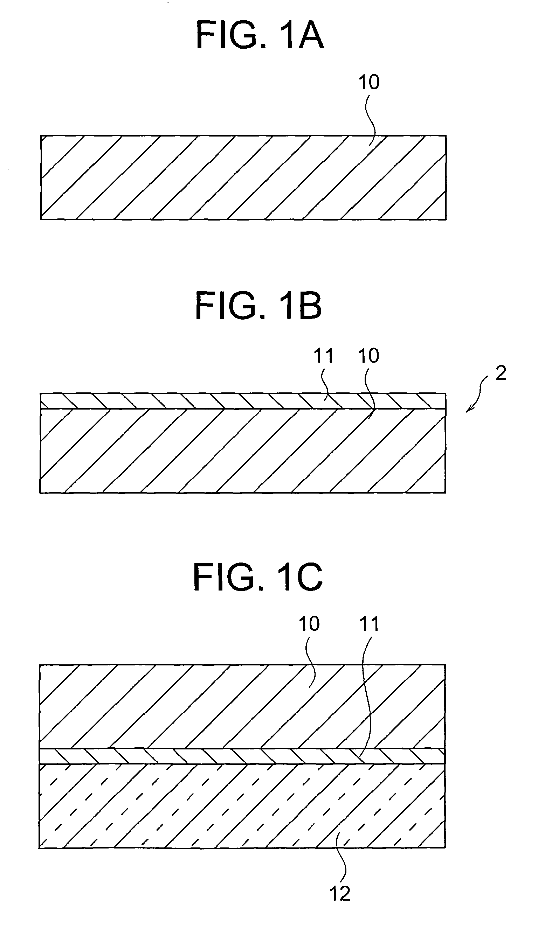

As shown in FIG. 1B, a magnetic garnet single crystal film formation substrate 2 in the present embodiment comprises a base substrate 10 and a buffer layer 11 formed by stacking on a growing surface of the base substrate 10. The base substrate 10 has a lattice constant and thermal expansion coefficient being extremely close to those of a magnetic garnet single crystal film 12 made by bismuth-substituted rare earth iron garnet single crystal shown in FIG. 1C but is unstable with a lead oxide flux. The buffer layer 11 is composed of a garnet-based single crystal thin film being stable with a lead oxide flux.

A bismuth-substituted rare earth iron garnet single crystal film 12 is grown on the buffer layer 11 in the substrate 2 by liquid phase epitaxial growth as shown in FIG. 1C. The base substrate 10 has preferable lattice matching property with the single crystal film 12 for growing the magnetic garnet single crystal film 12 via the buffer layer 11 and the linear thermal expansion coefficient of the substrate has a characteristic close to that of the single crystal film 12.

The base substrate 10 is composed of, for example, nonmagnetic garnet-based single crystal expressed by a general formula M1ₓM2_{y}M3_{z}O₁₂. In this general formula, M1 is an element, for example, selected from Ca, Sr, Cd and Mn. As the M1, those existing stably when having 2+ valence number, having a coordination number of 8, having an ion radius in a range of 0.096 to 0.126 nm in this state are preferable. The M2 is an element, for example, selected from Nb, Ta and Sb. As the M2, those existing stably when having 5+ valence number, having a coordination number of 6, having an ion radius in a range of 0.060 to 0.064 nm in this state are preferable. The M3 is an element, for example, selected from Ga, Al, Fe, Ge, Si and V. As the M3, those existing stably when having 3+, 4+ or 5+ valence number, having a coordination number of 4, having an ion radius in a range of 0.026 to 0.049 nm in this state are preferable. Note that the ion radius is a value of an effective ion radius defined by R. D. Shannon. The M1, M2 and M3 may be a single element or combination of two or more kinds of elements.

Furthermore, in the element of the M1, a part thereof may be substituted with an element M4 which is substitutable with Ca or Sr in the composition in a range of less than 50 atomic% in accordance with need in order to adjust the valence number and lattice constant. As the M4, for example, at least one kind selected from Cd, Mn, K, Na, Li, Pb, Ba, Mg, Fe, Co, rare earth elements and Bi and those capable of having a coordination number of 8 are preferable.

Also, in the M2, in the same way as in the M1, a part thereof may be substituted with an element M5 which is substitutable with Nb, Ta or Sb in the composition in a range of less than 50 atomic%. As the M5, for example, at least one kind selected from Zn, Mg, Mn, Ni, Cu, Cr, Co, Ga, Fe, Al, V, Sc, In, Ti, Zr, Si and Sn and those capable of having a coordination number of 6 may be preferably mentioned.

The single crystal substrate having a composition as above has a thermal expansion coefficient close to that of bismuth-substituted rare earth iron garnet single crystal to be grown and has preferable lattice matching property with the single crystal. Particularly, in the above general formula, those having values of "x" in a range of 2.98 to 3.02, "y" in a range of 1.67 to 1.72, and "z" in a range of 3.15 to 3.21 are preferable.

The thermal expansion coefficient of the base substrate 10 having the above composition is 1.02 × 10⁻⁵/°C to 1.07 × 10⁻⁵/°C or so in the room temperature to 850°C, which very much approximates the linear thermal expansion coefficient of 1.09 × 10⁻⁵/°C to 1.16 × 10⁻⁵/°C of bismuth-substituted rare earth iron garnet single crystal film in the same temperature range.

Also, the thickness of the base substrate 10 is not particularly limited, but the thickness is preferably 1.5 mm or less in terms of suppressing arising of cracks and warps, etc. of the substrate and the single crystal film at the time of film forming when forming a bismuth-substituted rare earth iron garnet single crystal film having a film thickness of 200 µm or more, so that a preferable single crystal film can be obtained. When the thickness of the base substrate exceeds 1.5 mm, there is a tendency that arising of cracks increases near a boundary surface of the substrate and the single crystal film along with an increase of the thickness. Also, when the thickness of the single crystal substrate 10 becomes too thin, mechanical strength becomes small and handleability becomes poor, so that those having a thickness of 0.1 mm or more are preferable.

The buffer layer 11 formed on the single crystal substrate 10 is composed of a garnet-based single crystal thin film. As the garnet-based single crystal thin film, what expressed by a general formula R₃M₅O₁₂ (note that R is at least one kind of rare earth elements and M is one kind selected from Ga and Fe), or X-substituted gadolinium gallium garnet (note that X is at least one kind of Ca, Mg and Zr) may be mentioned.

Among these, it is preferable to use one kind selected from neodymium gallium garnet, samarium gallium garnet, gadolinium gallium garnet and X-substituted gadolinium gallium garnet (note that X is at least one kind of Ca, Mg and Zr), but it is not limited to the above as far as it is a garnet-based material being stable with a lead oxide flux.

A method of producing the base substrate 10 in the magnetic garnet single crystal film formation substrate of the present invention is not particularly limited, and a method commonly used in producing a conventional GGG single crystal substrate, etc. can be applied.

For example, first, a homogenous molten mixture is prepared wherein each of or two or more selected kinds of elements expressed by M1, elements expressed by M2 and elements expressed by M3 in the above general formula and each of or two or more selected kinds of elements expressed by M4 and elements expressed by M5 used depending on the case are contained at a predetermined ratio. Next, a polycrystalline body is formed from the molten mixture, for example, by dipping GGG seed crystal, etc. having a long axis direction of <111> perpendicular to the liquid surface and pulling up while slowly rotating.

Since there are a large number of cracks on the polycrystalline body, a single crystal portion without a crack is selected from that and, after confirming the crystal orientation, it is dipped as a seed crystal in the above molten mixture so that the crystal orientation <111> becomes perpendicular to the liquid surface and pulled up while slowly rotating, consequently, a single crystal without a crack is formed. Next, the single crystal is cut perpendicular to the growth direction to be a predetermined thickness, performing mirror polishing on the both surfaces, and performing etching processing, for example, with heat phosphoric acid, etc. to obtain the base substrate 10 shown in FIG. 1A.

The buffer layer 11 composed of a garnet-based single crystal thin film having the above composition is formed on the thus obtained base substrate 10 as shown in FIG. 1B by a sputtering method, a CVD method, a pulse laser deposition method, or other thin film formation technique in the present embodiment. Note that the crystal growing surface of the base substrate 10 is preferably made planarized by polishing processing, etc. before forming the buffer layer 11.

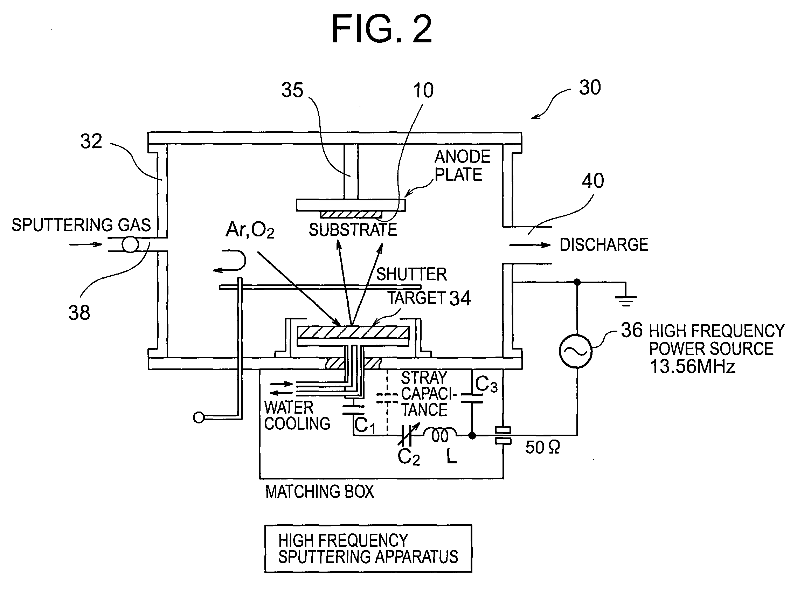

When forming the buffer layer 11 by the sputtering method, for example, the sputtering apparatus 30 shown in FIG. 2 is used. The sputtering apparatus 30 comprises a chamber 32, a target 34 held inside the chamber 32 and a holding mechanism 35 for holding the base substrate 10 placed in the chamber to face to the target 34. The target 34 is to be applied with a high-frequency high voltage from a power source 36. A sputtering gas is introduced into the chamber 32 through a pipe 38, and inside the chamber 32 is to be kept at a predetermined vacuum degree by a vacuum pump, etc. connected to an outlet 40.

In the present embodiment, inside the chamber 32 is kept to be 0.1 to 10 Pa, and preferably 0.5 to 3 Pa and the target 34 is applied with input power of 2 to 10 W/cm², and more preferably 3 to 6 W/cm² from the power source 36 at the time of sputtering. By controlling the input power in the ranges, a high quality buffer film can be formed.

Also, inside the chamber 32, a sputtering gas, which is an inert gas such as Ar including oxygen (O₂) by 35 volume% or less, and more preferably 10 to 30 volume%, is introduced through the pipe 38. When using a sputtering gas (an atmosphere gas) not including oxygen at all, a crystal quality of the buffer layer 11 tends to become deteriorated, while when the oxygen amount is too much, abnormal discharging, etc. are caused and it is liable that a high quality buffer layer 11 is hard to be obtained.

In the present embodiment, the base substrate 10 is not heated in a positive manner by the holding mechanism 35 at the time of sputtering. Note that the temperature of the substrate 10 rises over time due to an effect of the sputtering processing, but the temperature of the substrate 10 is consequently controlled from the room temperature to 600°C, preferably from the room temperature to 300°C, and particularly preferably from the room temperature to 100°C.

A thickness of the buffer layer 11 formed on the base substrate 10 by the above sputtering processing is in a range of preferably 1 to 10000 nm, and more preferably 5 to 50 nm. When the thickness of the buffer layer 11 is too thin, an effect of the present invention becomes small, while when too thick, it is liable that the cost increases and cracks and other adverse effects are given to an epitaxial growing film due to a difference of the thermal expansion coefficient.

By using the magnetic garnet single crystal film formation substrate 2 configured as above, a magnetic garnet single crystal film 12 composed of a bismuth-substituted rare earth iron garnet single crystal film is formed as shown in FIG. 1C by the liquid phase epitaxial growth method.

A composition of the bismuth-substituted rare earth iron garnet single crystal film composing the magnetic garnet single crystal film 12 is expressed by, for example, a general formula BiₘR₃₋ₘFe₅₋ₙMnO₁₂ (R is at least one kind of rare earth elements, M is at least one kind of element selected from Ga, Al, In, Sc, Si, Ti, Ge and Mg, and ranges of "m" and "n" are 0<m<3.0 and 0≤n≤1.5 in the formula).

In the general formula, as the rare earth element expressed by R, for example, Y, La, Pr, Nd, Sm, Eu, Gd, Tb, Dy, Ho, Er, Tm, Yb, Lu, etc. are mentioned, and one or more kinds of these may be included.

In the single crystal, a part of the rare earth element expressed by R is substituted with bismuth, the ratio of the substitution with bismuth is expressed by "m" and the value of "m" is in a range of 0<m<3.0. Particularly when "m" is in the range of 0.5 to 1.5, the thermal expansion coefficient of the single crystal and that of the single crystal substrate become extremely close, so it is advantageous. Also, "M" is a nonmagnetic element substitutable with Fe, which are Ga, Al, In, Sc, Si, Ti, Ge and Mg, and one or more kinds of these may be included. The ratio "n" of the substitution with Fe in the nonmagnetic element is selected from the range of 0 to 1.5.

To form a bismuth-substituted rare earth iron garnet single crystal film by the liquid phase epitaxial growth method, a homogenous molten mixture containing a predetermined ratio of (1) a bismuth oxide, (2) at least one kind of rare earth element oxide, (3) an ion oxide and if necessary (4) an oxide of at least one kind of element selected from Ga, Al, In, Sc, Si, Ti, Ge and Mg used depending on the case is prepared. As a solute for precipitation, a lead oxide is normally used as a main component, but a bismuth oxide or other solute for precipitation may be used. Also, a boron oxide, etc. may be also included as a crystal growth auxiliary if desired.

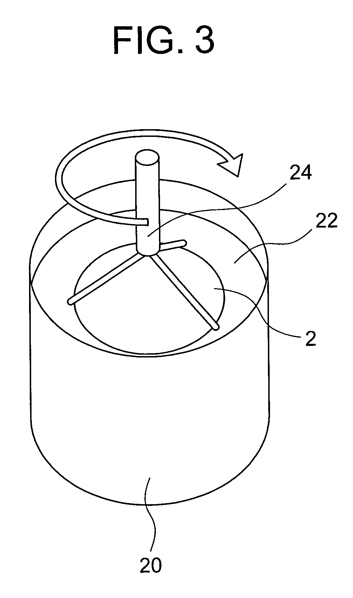

Next, by dipping the substrate 2 of the present invention in the molten mixture (a solute flux 22 in a crucible 20 shown in FIG. 3), a single crystal is grown by epitaxial-growth from the molten mixture on a surface of the buffer layer 11 of the substrate 2 so as to form a magnetic garnet single crystal film 12. A temperature of the molten mixture at this time varies depending on a composition of the material mixture, but is normally selected from a range of 600 to 1000°C. Also, the substrate 2 may be subjected to epitaxial growth by being left in the molten mixture or by being suitably rotated around a rotation axis 24 shown in FIG. 2. When rotating the substrate 2, the speed of the rotation is preferably 10 to 200 rpm. Also, the speed of film formation is normally 0.08 to 0.8 µm/minute or so. The dipping time varies depending on the film formation speed and a desired film thickness, etc. and cannot be determined as a rule, but is normally 10 to 100 hours or so.

After finishing the epitaxial growth, the substrate 2 is pulled out from the molten mixture and adhered molten mixture is sufficiently swished off, then, cooled to the room temperature. Next, after a caked substance of the molten mixture adhered to the surface of the formed single crystal film is removed by being dipped in a mineral acid solution of aqua fortis, etc., it is washed with water and dried. The thickness of the magnetic garnet single crystal film 12 composed of bismuth-substituted rare earth iron garnet single crystal formed on the substrate 2 as above is normally in a range of 100 to 1000 µm. Also, the thermal expansion coefficient is 1.0 × 10⁻⁵/°C to 1.2 × 10⁻⁵/°C or so in the room temperature to 850°C.

As explained above, the crystal structure and composition of the bismuth-substituted rare earth iron garnet single crystal film formed on the substrate 2 can be identified respectively by composition analysis by X-ray diffraction and a fluorescent X-ray, etc. Also, performance of the single crystal film 12 can be evaluated by removing the substrate 2 (the base substrate 10 + the buffer layer 11) from the single crystal film 12 by polish processing, etc., then, performing polish processing on both surfaces of the film 12, providing non-reflection film on the both surfaces, and obtaining a Faraday rotation coefficient, transmission loss and temperature property, etc.

### Second Embodiment

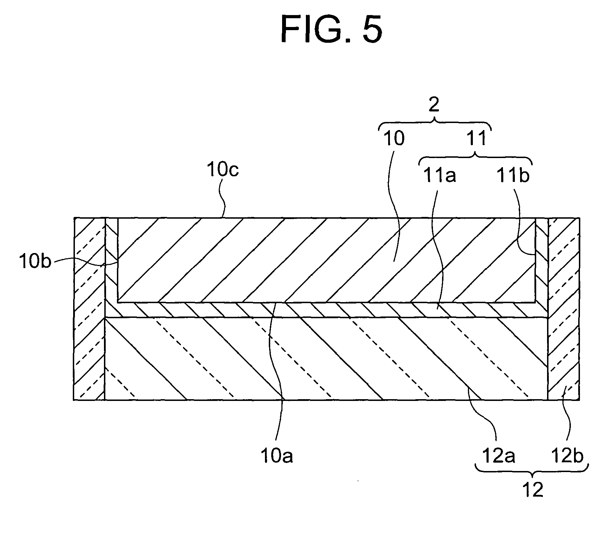

As shown in FIG. 5, in the present embodiment, the buffer layer 11 is formed not only on the bottom surface (crystal growing surface) 10a of the base substrate 10 but also formed continuously over entire side surfaces 10b of the base substrate 10. Other configuration and the operation are the same as those in the first embodiment, so that the detailed explanation will be omitted.

In the present embodiment, the buffer layer 11 is composed of a bottom surface buffer layer 11a formed on the bottom surface 10a of the base substrate 10 and a side surface buffer layer (side surface protective film) 11b formed on the side surfaces 10b of the base substrate 10.

In the present embodiment, the buffer layer 11 is formed not only on the bottom surface 10a of the base substrate 10 but on the side surfaces 10b of the base substrate 10. Therefore, in the present embodiment, not only the bottom surface 10a but the side surfaces 10b of the base substrate 10 are also polished and the films are formed under a condition that the buffer layer 11 is formed also on the side surfaces 10b. For example, when applying a sputtering method, by making the film formation pressure 0.1 to 10 Pa, and preferably 1 to 3 Pa, the side surface protective layer 11b is formed also on the side surfaces 10b in addition to the bottom surface 10a of the base substrate 10. Alternately, when applying the MOCVD method, the side surface buffer layer 11b is formed also on the side surfaces 10b in addition to the bottom surface 10a of the base substrate 10 under a general film formation condition.

In the present invention, a material of the bottom surface buffer layer 11a formed on the bottom surface 10a of the base substrate 10 and a material of a side surface buffer layer 11b formed on the side surfaces 10b of the base substrate 10 may be different or same. Note that the buffer layers 11a and 11b are preferably formed at a time. By doing so, a step of forming the buffer layer 11 can be reduced.

Note that the side surface buffer layer 11b may be poor in the film quality comparing with the bottom surface buffer layer 11a. It is because the garnet film 12b to be formed on the surface of the side surface buffer layer 11b is a part that may be removed in a later step. For example, only the bottom surface buffer layer 11a is formed by the sputtering method described in the first embodiment and the side surface buffer layer 11b may be formed by applying a chemical solution deposition method, such as the sol gel method. Alternately, a solution for forming the side surface buffer layer (side surface protective film) 11b may be applied by using a brush or spray, etc.

In the present embodiment, a thickness of the bottom surface buffer layer 11a and a thickness of the side surface buffer layer 11b may be same or different. Note that the thicknesses of the buffer layers 11a and 11b are preferably in a range of 1 to 10000 nm, and more preferably 5 to 50 nm. When the thickness of the buffer layers 11a and 11b are too thin, an effect of the present invention becomes small, while when too thick, the cost increases and cracks and other adverse effects tend to be given to an epitaxial growing film due to a difference of the thermal expansion coefficient, etc.

By using a magnetic garnet single crystal film formation substrate 2 configured as above, a magnetic garnet single crystal film 12 composed of a bismuth-substituted rare earth iron garnet single crystal film is formed by the liquid phase epitaxial growth method. In the present embodiment, the side surface growing film (not always a single crystal film) 12b is formed not only on the bottom surface but also on the side surfaces of the magnetic garnet single crystal film formation substrate 2. Note that the side surface growing film 12b formed on the side surfaces of the substrate 2 is generally poor in the film quality comparing with the bottom surface single crystal film 12a formed on the bottom surface and removed later on.

In the present embodiment, when using the single crystal film 12 as an optical element, it is preferable that the side surface growing film 12b formed on the side surfaces of the substrate 2 is removed by polishing processing, etc. to form the optical element only by the single crystal film 12a formed on the bottom surface of the substrate 2.

Particularly, in the present embodiment, the buffer layer 11 is formed also on the side surfaces of the base substrate crossing with the crystal growing surface in addition to the crystal growing surface of the base substrate 10, the side surfaces of the base substrate 10 do not react with a flux, so that a quality of the magnetic garnet single crystal film 12 improves and the production yield also improves.

Note that the present invention is not limited to the above embodiment and may be variously modified within the scope of the present invention. For example, in the embodiment shown in FIG. 1, the buffer layer 11 was formed only on the bottom surface 10a and the side surfaces 10b of the base substrate 10, but the buffer layer 11 may be formed allover the base substrate 10 including the upper surface 10c of the base substrate 10.

### [EXAMPLES]

Below, the present invention will be explained based on further detailed examples, but the present invention is not limited to the examples.

### Example 1

CaCO₃, Nb₂O₅ and Ga₂O₃ were weighed, fired at 1350°C in the air, and after confirming a garnet single phase, put in an iridium melting pot, heated to be about 1450°C by high frequency induction in a mixed gas atmosphere of 98 volume% of a nitrogen gas and 2 volume% of an oxygen gas and melted, so that a composition of the melt becomes Ca₃Nb_{1.7}Ga_{3.2}O₁₂. After that, a seed crystal of the above composition having a 5mm square column shape wherein the long axis direction is <111> is dipped in this melt to be perpendicular to the liquid surface and pulled up at a speed of 3 mm/hour while rotating at 20 rpm, consequently, transparent single crystal having no cracks at all was obtained.

Next, a sample of about 1g was cut from each of its upper portion and lower portion of the crystal for quantitative analysis of respective composing elements by a fluorescent X-ray analysis apparatus. It was confirmed that both of the upper portion and the lower portion of the crystal had a composition of Ca₃Nb_{1.7}Ga_{3.2}O₁₂ (CNGG).

The obtained single crystal was cut to be a predetermined thickness vertically to the growing direction, and after performing mirror-polishing on the both sides, etching processing with heat phosphoric acid was performed, so that a CNGG single crystal substrate (base substrate 10) was prepared. The thermal expansion coefficient (α) of the single crystal substrate at the room temperature to 850°C was 1.07 × 10⁻⁵/°C. The thickness of the CNGG single crystal substrate was 0.6 mm.

An Nd₃Ga₅O₁₂ (NGG) thin film (buffer layer 11) was formed by the sputtering method on the crystal growing surface of the CNGG single crystal substrate. Specifically, an NGG sintered body was used as a target, sputtering film formation was performed under film formation condition below, and anneal processing was performed after that.

### [Sputtering Film Formation Condition]

substrate temperature: 20°C (the room temperature without heating)
input power: 3.7 W/cm²
atmosphere: Ar + O₂ (10 volume%), 1 Pa
film formation time: 30 minutes
film thickness of buffer layer 11: 50 nm

### [Anneal Processing]

atmosphere: O₂, 1 atm
temperature: 800°C
time: 30 minutes

When conducting composition analysis of the thus obtained NGG film by a fluorescent X-ray, it was confirmed that a Nd₃Ga₅O₁₂ (NGG) thin film having an approximate stoichiometric composition was obtained. Also, when examining a peak position of the CNGG substrate and a peak position of the NGG film by the X-ray reciprocal lattice space mapping method to check the crystal property of the NGG film, the peak positions were close and a peak width (a locking curve full-width at half maximum) was small as 0.03°, so that it was confirmed to be a crystal property at a very high quality.

By using the thus obtained CNGG substrate (substrate 2) added with NGG films, a bismuth-substituted rare earth iron garnet single crystal film was formed by the liquid phase epitaxial growth method. Specifically, 5.747g of Ho₂O₃, 6.724g of Gd₂O₃, 43.21g of B₂O₃, 126.84g of Fe₂O₃, 989.6g of PbO and 826.4g of Bi₂O₃ were put in a melting pot made by platinum, melted at about 1000°C and mixed to be homogenized, then, cooled at a rate of 120°C/hr. and kept in a supersaturated state at 832°C. Next, the substrate 2 obtained by the above method was dipped in this melt solution and liquid phase epitaxial growth was performed for 40 hours to grow a single crystal film while rotating the substrate at 100 rpm, so that a bismuth-substituted rare earth iron garnet single crystal film 12 having a film thickness of 450 µm was formed on the bottom surface (crystal growing surface) of the substrate 2.

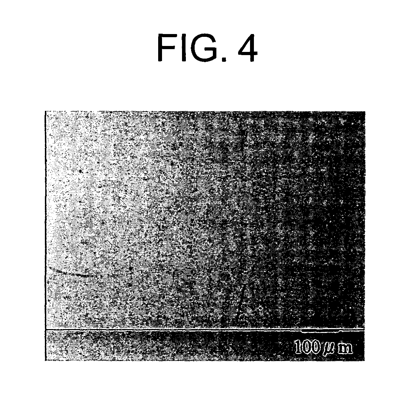

When analyzing a composition of the single crystal film 12 formed on the bottom surface of the substrate 2 by a fluorescent X-ray method, it was confirmed to be Bi_{1.1}Gd_{1.1}Ho_{0.8}Fe_{5.0}O₁₂ (Bi-RIG) . A result of taking an optical microscope picture of a surface of the single crystal film 12 is shown in FIG. 4.

It was confirmed that a Bi-RIG single crystal film having a flat, smooth and fine surface and of an approximate stoichiometric composition could be formed by epitaxial growth without causing any cracks and flaking. Also, from the picture shown in FIG. 4, when examining surface defect (etch pit/ black points shown in FIG. 4) density by the area ratio, it was 0.16% and it was confirmed that the defects were a little.

Also, when measuring a difference of a lattice constant of the single crystal film and that of the CNGG substrate as a base substrate, it was confirmed to be 0.009Å and within ±0.02Å. Note that when measuring a difference of the lattice constant of the single crystal film and that of the NGG thin film as a buffer layer, it was 0.007Å. Measurement of the lattice constant was made by an X-ray diffraction method.

Also, by removing the substrate 2 (the base substrate 10 and the buffer layer 11) from the single crystal film 12 by polishing processing, performing polishing processing on the both sides of the single crystal film 12, adhering a non-reflection film made by SiO₂ or Ta₂O₅ on both sides thereof, and evaluating a Faraday rotation angle at a wavelength of 1.55 µm and a transmission loss at a Faraday rotation angle of 45 degrees and a temperature characteristic, the Faraday rotation coefficient was 0.125 deg/µm, the transmission loss was 0.05 dB, and the temperature characteristic was -0.065 deg/°C. These were all at satisfactory levels as optical characteristics of an optical isolator.

Note that the Faraday rotation angle was obtained by letting a polarized laser light having a wavelength of 1.55 µm enter the single crystal film and measuring an angle of the deflecting surface of the emitted light. The transmission loss was obtained from a difference of intensity of the laser light having a wavelength of 1.55 µm passed through the single crystal film and light intensity in a state without a single crystal film. The temperature characteristic was calculated from a value obtained by measuring a rotation angle by changing a temperature of the sample from -40°C to 85°C.

Furthermore, the thermal expansion coefficient (α) of the single crystal film at the room temperature to 850°C was 1.10 × 10⁻⁵/°C. The difference of the thermal expansion coefficient between the base substrate and the single crystal film was 0.03 × 10⁻⁵/°C. Also, arising of cracks was not observed in the obtained single crystal film.

### Example 2

Other than performing anneal processing at 600°C and 900°C on a buffer layer after forming the buffer layer on the base substrate, an NGG film as a buffer layer was formed on a surface of the CNGG substrate as the base substrate in the same way as in the example 1.

When examining a peak width (a locking curve full-width at half maximum) of the NGG film in the same way as in the example 1, a peak was not detected under the annealing condition of 600°C, and the peak width was 0.1 to 0.2° under the annealing condition of 900°C. It was confirmed that when the temperature of the annealing processing is too low, it is liable that crystallization of the buffer layer becomes insufficient and a high quality buffer layer is hard to be obtained, while when the temperature is too high, the crystal quality of the buffer layer tends to become deteriorated.

### Example 3

Other than changing the volume% of oxygen (O₂) in the atmosphere gas (an inert gas, such as Ar) at the time of sputtering to 0 volume%, 20 volume%, 30 volume% and 35 volume% when forming a buffer layer by the sputtering method, an NGG film as a buffer layer was formed on a surface of the CNGG substrate as the base substrate in the same way as in the example 1.

When examining a peak width (a locking curve full-width at half maximum) of the NGG film in the same way as in the example 1, it was 0.2° under the condition of 0 volume%, 0.03° under the condition of 20 volume%, 0.03° under the condition of 30 volume%, and 0.1° under the condition of 35 volume%.

From the above results, it was confirmed that the crystal quality of the buffer layer tended to be deteriorated in an atmosphere gas not including oxygen at all, while when the oxygen amount was too much, abnormal discharging, etc. were caused and it was liable that a high quality buffer was hard to be obtained.

### Example 4

Other than changing the input power at sputtering to 2, 6, 8 and 10 W/cm² when forming the buffer layer by the sputtering method, an NGG film as a buffer layer was formed on a surface of the CNGG substrate as the base substrate in the same way as in the example 1.

When examining a peak width (locking curve half-value width) of the NGG film in the same way as in the example 1, it was 0.03° under the condition of 2W/cm², 0.15° under the condition of 6W/cm², 0.3° under the condition of 8W/cm², and 0.4° under the condition of 10W/cm².

From the above results, it was confirmed that by controlling the input power at sputtering to 2 to 10 W/cm², and preferably 3 to 6 W/cm², a high quality buffer film could be formed. It was also confirmed that when the input power was too small, it was liable that the film forming speed became slow and the productivity declined, while when too much, it was liable that the base substrate was damaged to deteriorate the crystal property and breaking of the sputtering target, etc. arose.

### Example 5

A CNGG single crystal substrate was prepared in the same method as in the above example 1.

A Gd_{2.65}Ca_{0.35}Ga_{4.05}Mg_{0.3}Zr_{0.65}O₁₂ (GCGMZG) thin film (buffer layer 11) was formed on the bottom surface of the CNGG single crystal substrate (base substrate 10) by the pulse laser vapor deposition method. Spedifically, a KrF excimer laser was irradiated at an irradiation laser density of 2.0 J/cm² on a GCGMZG single crystal target, and a GCGMZG thin film having a film thickness of about 10 nm was formed under an oxygen partial pressure of 1 Pa and an irradiation time of 5 minutes on the bottom surface of the CNGG substrate kept at a substrate temperature of 20°C. After that, anneal processing was performed under the same condition as that in the example 1. When conducting fluorescent X-ray analysis on the GCGMZG thin film, it was confirmed to be a GCGMZG having the same composition as that of the target.

By using the thus obtained CNGG single crystal substrate added with the GCGMZG thin film, a bismuth-substituted rare earth iron garnet single crystal film was formed by the same liquid phase epitaxial growth method as in the example 1. Arising of cracks was not observed in the obtained single crystal film.

### Example 6

A CNGG single crystal substrate added with an NGG thin film was prepared in the same method as in the above example 1. By using the CNGG single crystal substrate added with an NGG thin film, a bismuth-substituted rare earth iron garnet single crystal film was formed by the liquid phase epitaxial growth method.

Specifically, 12.431g of Tb₄O₇, 1.464g of Yb₂O₃, 43.21g of B₂O₃, 121.56g of Fe₂O₃, 989.6g of PbO and 826.4g of Bi₂O₃ are put in a melting pot made by platinum, melted at about 1000°C, mixed to be homogenized, cooled at a rate of 120°C/hr. and kept in a supersaturated state at 840°C. Next, a single crystal substrate material obtained by forming an NGG thin film of 250 nm on a CNGG substrate having a substrate thickness of 0.6 mm is dipped in this solution, liquid phase epitaxial growth was performed for 43 hours to grow a single crystal film while rotating the substrate at 100 rpm, so that a bismuth-substituted rare earth iron garnet single crystal film having a film thickness of 560 µm was formed on the substrate.

Arising of cracks was not observed in both of the obtained single crystal film and single crystal substrate. When analyzing a composition of the single crystal film by the fluorescent X-ray method, it was confirmed to be Bi_{1.0}Tb_{1.9}Yb_{0.1}Fe_{5.0}O₁₂·

Also, when measuring a difference of a lattice constant of the single crystal film and that of the CNGG substrate as a base substrate, it was confirmed to be 0.005Å and within ±0.02Å. Note that when measuring a difference of the lattice constant of the single crystal film and that of the NGG thin film as a buffer layer, it was 0.004Å.

Also, when evaluating a Faraday rotation angle at a wavelength of 1.55 µm and a transmission loss at a Faraday rotation angle of 45 degrees and temperature characteristic, the Faraday rotation coefficient was 0.090 deg/µm, the transmission loss was 0.15 dB, and the temperature characteristic was -0.045 deg/°C. Furthermore, the thermal expansion coefficient of the single crystal film was 1.09 × 10⁻⁵/°C. The difference of the thermal expansion coefficient between the base substrate and the single crystal film was 0.02 × 10⁻⁵/°C. Also, arising of cracks was not observed in the obtained single crystal film.

### Example 7

A CNGG single crystal substrate added with an NGG thin film was prepared in the same method as in the above example 1. By using the CNGG single crystal substrate added with the NGG thin film, a bismuth-substituted rare earth iron garnet single crystal film was formed by the liquid phase epitaxial growth method.

Specifically, 7.653g of Gd₂O₃, 6.778g of Yb₂O₃, 43.21g of B₂O₃, 113.2g of Fe₂O₃, 19.02g of Ga₂O₃, 3.35g of Al₂O₃, 869.7g of PbO and 946.3g of Bi₂O₃ are put in a melting pot made by platinum, melted at about 1000°C, mixed to be homogenized, cooled at a rate of 120°C/hr. and kept in a supersaturated state at 829°C. Next, a single crystal substrate material obtained by forming 250 nm of an NGG thin film on a CNGG substrate having a substrate thickness of 0.6 mm is dipped in this solution, liquid phase epitaxial growth was performed for 43 hours to grow a single crystal film while rotating the substrate at 100 rpm, so that a bismuth-substituted rare earth iron garnet single crystal film having a film thickness of 520 µm was formed on the substrate.

Arising of cracks was not observed in both of the obtained single crystal film and single crystal substrate. When analyzing a composition of the single crystal film by the fluorescent X-ray method, it was confirmed to be Bi_{1.3}Gd_{1.2}Yb_{0.5}Fe_{4.2}Ga_{0.6}Al_{0.2}O₁₂.

Also, when measuring a difference of a lattice constant of the single crystal film and that of the CNGG substrate as a base substrate, it was confirmed to be 0.014Å and within ±0.02Å. Note that when measuring the difference of the lattice constant of the single crystal film and that of the NGG thin film as a buffer layer, it was 0.013Å.

Also, when evaluating a Faraday rotation angle at a wavelength of 1.55 µm and a transmission loss at a Faraday rotation angle of 45 degrees and temperature characteristic, the Faraday rotation coefficient was 0.113 deg/µm, the transmission loss was 0.05 dB, and the temperature characteristic was -0.095 deg/°C. Furthermore, the thermal expansion coefficient of the single crystal film was 1.05 × 10⁻⁵/°C. The difference of the thermal expansion coefficient between the base substrate and the single crystal film was 0.02 × 10⁻⁵/°C. Also, arising of cracks was not observed in the obtained single crystal film.

### Example 8

Other than changing a pressure in the chamber to 3 Pa when forming an NGG film as a buffer layer on the CNGG substrate as the base substrate by the sputtering method and forming the buffer layer also on side surfaces of the CNGG substrate as the base substrate as shown in FIG. 5, a CNGG single crystal substrate added with an NGG thin film was prepared in the same way as in the example 1. By using the CNGG single crystal substrate added with an NGG thin film, a bismuth substituted rare earth iron garnet single crystal film was formed by the liquid phase epitaxial growing method in the same way as in the example 1.

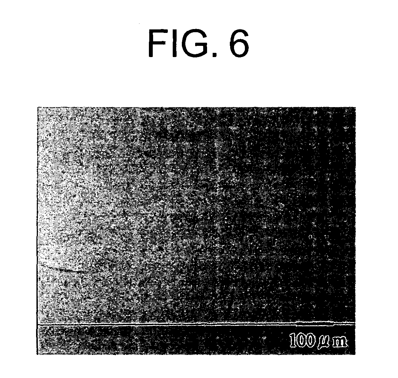

A result of taking a picture of a surface of the single crystal film by an optical microscope is shown in FIG. 6. From the result shown in FIG. 6, when examining surface defect (etch pit/ black points shown in FIG. 6) density by the area ratio, it was 0.04%. It was confirmed that the defect density declined in the result shown in FIG. 6 comparing with the result shown in FIG. 4.

### Comparative Example 1

A CNGG single crystal substrate was prepared in the same method as in the example 1, and a bismuth-substituted rare earth iron garnet single crystal film was formed by the liquid phase epitaxial growth method in the same way as in the example 1 without forming thereon a buffer layer composed of a single crystal thin film being stable with a lead oxide.

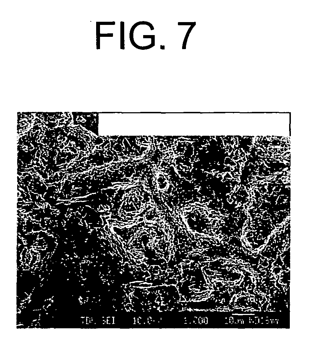

FIG. 7 is a SEM image of a surface of a substrate after the experiment, and it was confirmed that the surface was etched much. Also, it was found by the fluorescent X-ray analysis that a bismuth-substituted rare earth iron garnet single crystal film was not formed.

The above explained embodiments and examples are for illustrating the present invention and not to limit the present invention, and the present invention can be carried out in a variety of other modified embodiments.

### Effect of the Invention

As explained above, according to the present invention, it is possible to provide a magnetic garnet single crystal film formation substrate capable of stably forming a thick magnetic garnet single crystal film, wherein crystal defects, warps, cracks and flaking, etc. are not caused, having a high quality at a high yield at a low cost by liquid phase epitaxial growth, an optical element and the production method.

## Claims

1. A method of producing a magnetic garnet single crystal film formation substrate for growing a magnetic garnet single crystal film by liquid phase epitaxial growth, comprising the steps of:
forming a base substrate composed of a garnet-based single crystal being unstable with a flux used for the liquid phase epitaxial growth;
forming a buffer layer composed of a garnet-based single crystal thin film formed at least on a crystal growing surface of said base substrate and being stable with said flux; and
forming said buffer layer on said base substrate without a positive heating of said substrate when forming said buffer layer on said base substrate.

2. A method of producing a magnetic garnet single crystal film formation substrate for growing a magnetic garnet single crystal film by liquid phase epitaxial growth, comprising the steps of:
forming a base substrate composed of a garnet-based single crystal being unstable with a flux used for the liquid phase epitaxial growth;
forming a buffer layer composed of a garnet-based single crystal thin film formed at least on a crystal growing surface of said base substrate and being stable with said flux; and
forming said buffer layer on said base substrate by controlling a temperature of said substrate to be from the room temperature to lower than 600°C when forming said buffer layer on said base substrate.

3. The method of producing a magnetic garnet single crystal film formation substrate as set forth in claim 1 or 2, wherein after forming the buffer layer on said base substrate, anneal processing at 600 to 900°C is performed on said buffer layer.

4. The method of producing a magnetic garnet single crystal film formation substrate as set forth in any one of claims 1 to 3, wherein said buffer layer is formed by a thin film formation method.

5. The method of producing a magnetic garnet single crystal film formation substrate as set forth in claim 4, wherein said buffer layer is formed by the sputtering method.

6. The method of producing a magnetic garnet single crystal film formation substrate as set forth in claim 5, wherein oxygen is included by 30 volume% or less in an atmosphere gas at the time of sputtering when forming said buffer layer by the sputtering method.

7. The method of producing a magnetic garnet single crystal film formation substrate as set forth in claim 5 or 6, wherein input power at the time of sputtering is controlled to 2 to 10 W/cm² when forming said buffer layer by the sputtering method.

8. The method of producing a magnetic garnet single crystal film formation substrate as set forth in any one of claims 1 to 7, wherein a flux including a lead oxide and/or a bismuth oxide as a main component of said flux is used.

9. The production method of a magnetic garnet single crystal film formation substrate as set forth in any one of claims 1 to 8, wherein said base substrate has an approximately same thermal expansion coefficient as that of said magnetic garnet single crystal film.

10. The production method of a magnetic garnet single crystal film formation substrate as set forth in claim 9, wherein a difference between the thermal expansion coefficient of said base substrate and the thermal expansion coefficient of said magnetic garnet single crystal film is within a range of ±2 × 10⁻⁶/°C or less in a temperature range of 0°C to 1000°C.

11. The production method of a magnetic garnet single crystal film formation substrate as set forth in any one of claims 1 to 10, wherein said base substrate has an approximately same lattice constant as that of said magnetic garnet single crystal film.

12. The production method of a magnetic garnet single crystal film formation substrate as set forth in claim 11, wherein a difference between the lattice constant of said base substrate and the lattice constant of said magnetic garnet single crystal film is within a range of ±0.02Å or less.

13. The production method of a magnetic garnet single crystal film formation substrate as set forth in any one of claims 1 to 12, wherein said base substrate includes Nb or Ta.

14. The production method of a magnetic garnet single crystal film formation substrate as set forth in any one of claims 1 to 13, wherein said buffer layer is a garnet-based single crystal thin film substantially not including Nb and Ta.

15. The production method of a magnetic garnet single crystal film formation substrate as set forth in any one of claims 1 to 8, wherein said buffer layer is
expressed by a general formula R₃M₅O₁₂ (note that R is at least one of rare earth elements and M is one selected from Ga and Fe)
or
an X-substituted gadolinium gallium garnet (note that X is at least one of Ca, Mg and Zr).

16. The production method of a magnetic garnet single crystal film formation substrate as set forth in any one of claims 1 to 15, wherein a thickness of said buffer layer is 1 to 10000 nm and a thickness of said base substrate is 0.1 to 5 mm.

17. A magnetic garnet single crystal formation substrate produced by using the production method as set forth in any one of claims 1 to 16.

18. A method of producing a magnetic garnet single crystal film, comprising the step of growing a magnetic garnet single crystal film on said buffer layer by using the magnetic garnet single crystal film formation substrate as set forth in claim 17 by a liquid phase epitaxial growth method.

19. A method of producing an optical element, comprising the steps of forming a magnetic garnet single crystal film by using the production method of a magnetic garnet single crystal film as set forth in claim 18, and after that, removing said base substrate and buffer layer so as to form an optical element composed of a magnetic garnet single crystal film.

20. An optical element obtained by the production method of an optical element as set forth in claim 19.
